# EUROPÄISCHE PATENTSCHRIFT

(11) **EP 1 314 345 B1**
(45) Veröffentlichungstag und Bekanntmachung des Hinweises auf die Patenterteilung: **12.05.2004**
(21) Anmeldenummer: 01969608.7
(22) Anmeldetag: 17.08.2001
(51) Int. Cl.: H05K 7/14

(54) **BETÄTIGUNGSHEBEL MIT ANZEIGEELEMENT**
OPERATING LEVER WITH DISPLAY ELEMENT
LEVIER D'ACTIONNEMENT A ELEMENT D'AFFICHAGE

(30) Priorität: 17.08.2000 DE 20014199 U
(43) Veröffentlichungstag der Anmeldung: 28.05.2003
(73) Patentinhaber: RITTAL Electronic Systems GmbH & Co. KG, 35745 Herborn (DE)
(72) Erfinder: KOERBER, Werner, 91282 Betzenstein (DE); SCHAFFER, Kurt, Michael, 90542 Eckental (DE); BEHRENS, Ralf, 90419 Nürnberg (DE)
(74) Vertreter: Fleck, Hermann-Josef, Dr.-Ing.
(86) Internationale Anmeldenummer: PCT/EP2001/009525
(87) Internationale Veröffentlichungsnummer: WO 2002/019786

(56) Entgegenhaltungen:
- WO-A-96/42187
- US-A- 5 627 379
- PATENT ABSTRACTS OF JAPAN vol. 1995, no. 06, 31. Juli 1995 (1995-07-31) & JP 07 058462 A (NEC CORP), 3. März 1995 (1995-03-03)
- PATENT ABSTRACTS OF JAPAN vol. 2000, no. 02, 29. Februar 2000 (2000-02-29) & JP 11 307964 A (TOSHIBA CORP), 5. November 1999 (1999-11-05)

## Beschreibung

Die Erfindung betrifft ein Betätigungselement zum Ein- und Aushebeln einer Flachbaugruppe mit den Merkmalen des Oberbegriffs des Patentanspruchs 1. Ferner betrifft die Erfindung ein Frontsystem für eine Flachbaugruppe mit mindestens einem derartigen Betätigungselement, eine zugehörige Flachbaugruppe sowie einen Baugruppenträger zur ein- und aushebelbaren Aufnahme derartiger Flachbaugruppen mit einem Frontsystem.

Als Stand der Technik ist aus der Gebrauchsmusteranmeldung 299 22 725.1 (Siemens) ein Betätigungselement zum Ein- und Aushebeln einer Flachbaugruppe mit einem Endstück bekannt, welches zur Verbindung mit einer Flachbaugruppe vorbereitet ist und einen Betätigungshebel aufweist, der drehbar am Endstück gelagert ist.

Derartige Flachbaugruppen weisen üblicherweise elektrische Anzeigeelemente auf, die z. B. den Schaltzustand eines Schaltelements der Frontbaugruppe anzeigen und dabei üblicherweise separat in der Frontplatte der Frontbaugruppe integriert sind. Hierfür wird separater Bauraum benötigt.

Der Erfindung liegt die Aufgabe zugrunde, ein Betätigungselement zum Ein- und Aushebeln einer Flachbaugruppe anzubieten, welches ein besonders platzsparend angebrachtes elektrisches Anzeigeelement aufweist. Ferner soll ein zugehöriges Frontsystem für eine derartige Flachbaugruppe, eine Flachbaugruppe mit einem derartigen Frontsystem sowie ein Baugruppenträger zur ein- und aushebelbaren Aufnahme derartiger Flachbaugruppen angeboten werden.

Die Aufgabe wird für das Betätigungselement durch die Merkmale des kennzeichnenden Teils des Patentanspruchs 1 in Verbindung mit den Merkmalen des Oberbegriffs gelöst. Vorteilhafte Ausführungsformen des Betätigungselements sind in den Unteransprüchen 2 - 15 beschrieben. Für das Frontsystem wird die Aufgabe durch die Merkmale des Patentanspruchs 16, für die Flachbaugruppe durch die Merkmale des Patentanspruchs 17 und für den Baugruppenträger durch die Merkmale des Patentanspruchs 18 gelöst.

Beim erfindungsgemäßen Betätigungselement weist dessen Betätigungshebel mindestens ein elektrisches Anzeigeelement, insbesondere eines LED-Bauelements, auf. Hierdurch kann z.B. der Schaltzustand eines im Betätigungselement integrierten Schaltelements angezeigt werden. Im Gegensatz zum geschilderten Stand der Technik wird beim erfindungsgemäßen Betätigungselement kein separater Bauraum z.B. in der Frontplatte der Flachbaugruppe des Betätigungselements benötigt. Das elektrische Anzeigeelement ist erfindungsgemäß platzsparend und kompakt am Betätigungshebel des Betätigungselements angebracht.

Das Anzeigeelement kann auf vielfältige Art und Weise mit dem Betätigungselement verbunden und z.B. modulartig oder als Ergänzungsbauteil an der Außenseite des Betätigungselements angebracht sein.

Gemäß einer ersten Ausführungsform wird das Anzeigeelement teilweise oder völlig ins Griffteil des Betätigungshebels integriert. Hierdurch kann das Anzeigeelement besonders sicher vom Benutzer eingesehen werden.

Gemäß einer weiteren Ausführungsform ist das Anzeigeelement in einem Verriegelungselement des Betätigungselements teilweise oder völlig integriert. Damit ist das Anzeigeelement im geringem Abstand zu Stromversorgungskontakten der Flachbaugruppe angebracht.

Eine besonders bauraumsparende Lösung wird erreicht, wenn das Anzeigeelement in Ausnehmungen des Griffteils oder des Betätigungselements aufgenommen wird und somit gegenüber der bisherigen Oberfläche des Griffteils bzw. des Betätigungselements nur wenig zusätzlichen Bauraum benötigt oder bündig mit den jeweiligen Oberflächen abschließt.

Gemäß einer weiteren Ausführungsform kann das Betätigungselement auch mehrere Anzeigeelemente aufweisen, welche am Griffteil und/oder am Betätigungshebel angebracht sind. Hierdurch können vielfältige Schaltzustände des Schaltelements angezeigt und differenzierte Informationen optisch übertragen werden.

Wenn das Betätigungselement ein integriertes Schaltelement aufweist, welches durch Betätigung des Betätigungshebels beim Ein- und Aushebeln der Flachbaugruppe aktiv oder passiv geschaltet werden kann, dient das elektrische Anzeigeelement insbesondere zur Anzeige des Schaltzustandes des Schaltelements.

Wenn das Schaltelement über Anschlusskontakte von der Flachbaugruppe mit Strom versorgt wird, ist das Anzeigeelement elektrisch insbesondere mit dem Schaltelement zur Stromversorgung verbunden. Diese elektrische Verbindung kann durch lösbare Klemmkontakte erfolgen, so dass beim Herausziehen der Flachbaugruppe aus dem Baugruppenträger und damit beim Aushebeln des Betätigungshebels und/oder beim Verbringen des Verriegelungselements des Betätigungselements in eine zweite Schaltstellung (B) eine Öffnung der elektrischen Verbindung zwischen Anzeigeelement und Schaltelement auftritt. Ferner kann auch eine separate Stromversorgung des Anzeigeelements vorgesehen sein.

Beim erfindungsgemäßen Frontsystem für eine Flachbaugruppe ist eine Frontplatte mit mindestens einem erfindungsgemäßen Betätigungselement vorgesehen, bei dem ein elektrisches Anzeigeelement am Betätigungshebel des Betätigungselements angebracht ist.

Ferner ist eine Flachbaugruppe vorgesehen, welche ein Frontsystem mit einem erfindungsgemäßen Betätigungselement aufweist.

Schließlich umfasst die Erfindung ein Baugruppenträger, in dem Flachbaugruppen mit einem Frontsystem mit einem erfindungsgemäßen Betätigungselement ein- und aushebelbar sind.

Die Erfindung ist anhand von Ausführungsbeispielen in den Zeichnungsfiguren näher erläutert. Es zeigen:
- FIG 1: eine perspektivische Seitenansicht einer prinzipiellen Ausführung eines Betätigungselements nach dem Stand der Technik,
- FIG 2: eine seitliche Draufsicht auf ein Frontsystem für eine Flachbaugruppe mit einem Betätigungselement gemäß dem Stand der Technik nach FIG 1,
- FIG 3: eine perspektivische Ansicht einer prinzipiellen Ausführung eines erfindungsgemäßen Betätigungselements,
- FIG 4: eine Seitenansicht von FIG 3 sowie
- FIG 5: eine Draufsicht von FIG 3.

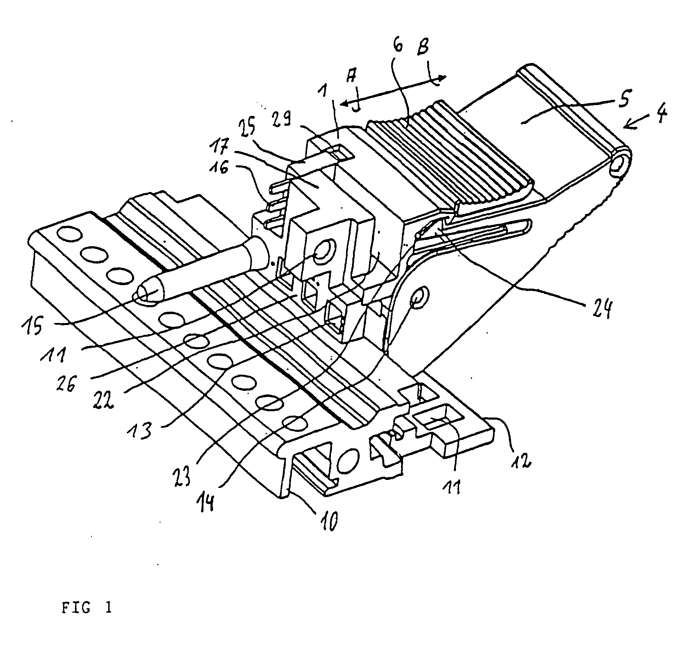

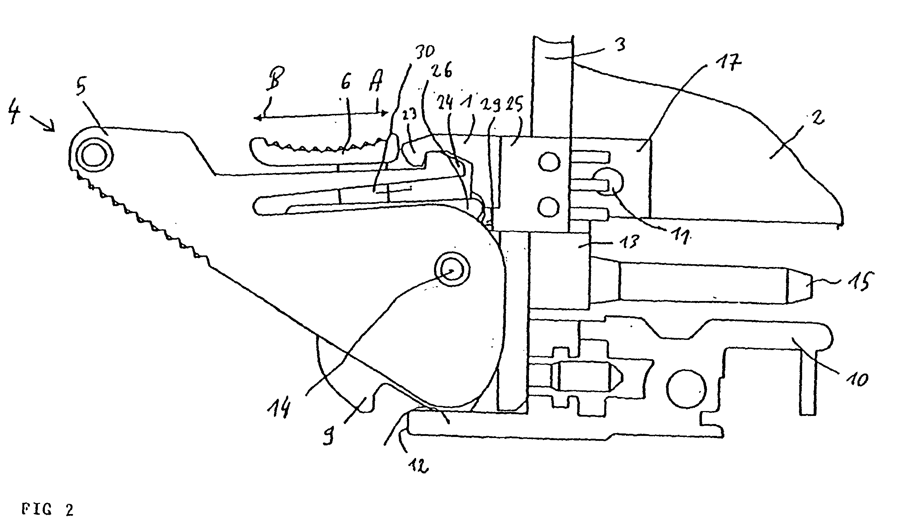

FIG 1 zeigt ein Betätigungselement nach dem Stand der Technik zum Ein- und Aushebeln einer Flachbaugruppe 2 mit einem Endstück 1 zur Verbindung mit einer Flachbaugruppe 2 und einer Frontplatte 3 (vgl. auch FIG 2).

Das Betätigungselement ruht dabei auf einer unteren Querschiene 10 eines Baugruppenträgers und weist dabei als Hauptkomponenten einen Betätigungshebel 4, ein Endstück 1 und eine aus Gründen der Übersichtlichkeit in FIG 1 nicht dargestellte Frontplatte 3 auf. Dem Endstück 1 kommt dabei eine zentrale Haltefunktion zu, da es zum einen als Träger für den insbesondere über eine Bohrung 14 drehbar gelagerten Betätigungshebel 4 dient. Andererseits kann es auch zur Halterung des unteren Endes der Frontplatte 3 dienen, welche hierzu vorteilhaft in eine Nut 22 eingeschoben wird.

Die Verbindung zwischen dem unteren Endstück 1 und der vorderen, unteren Ecke der Flachbaugruppe 2 (vgl. FIG 2) erfolgt bevorzugt über einen Halteblock 17 mittels einer in eine Bohrung 11 eingreifenden Schraube.

Schließlich können noch weitere Komponenten an einem derartigen Endstück 1 angebracht sein. So enthält das in FIG 1 dargestellte Endstück 1 einen Kodierblock 13, in welchem Kodierkammern 27 zum Einsetzen von nicht abgebildeten Kodierstiften eingebracht sind. Diese können in gegenüberliegend an der unteren Querschiene 10 angebrachten Kodierkammern eingreifen, welche mit komplementär kodierten Kodierstiften bestückt sind. Hiermit kann sichergestellt werden, dass nur eine bestimmte, ausgewählte Flachbaugruppe 2 in einem Steckplatz eines Baugruppenträgers positionierbar ist. Schließlich ist noch ein Führungsstift 15 vorhanden, welcher nach Eingriff in eine gegenüberliegende nicht abgebildete Führungsbohrung ein verkantfreies, ordnungsgemäßes Einschieben der Flachbaugruppe 2 gewährleistet.

Zum Ein- bzw. Aushebeln der Flachbaugruppe in den bzw. aus dem entsprechenden Steckplatz dient der Betätigungshebel 4, welcher durch Betätigung des Griffteils 5 bei Verbringung des Verriegelungselements 6 in Schaltstellung (B) bedient werden kann.

Beim Aushebeln muss der Betätigungshebel 4 nach unten gedrückt werden, so dass sich mindestens eine auf der Unterseite vorspringende Aushebelnase 9 an einer Stirnkante 12 der unteren Querschiene 10 abstützen kann. Umgekehrt muss beim Einhebeln der Betätigungshebel 4 nach oben gedrückt werden, so dass sich mindestens eine ebenfalls auf der Unterseite vorspringende Einhebelkante 8 im Inneren einer ebenfalls im Bereich der Stirnkante 12 der unteren Querschiene 10 befindlichen mindestens einen Eingriffsmulde 11 abstützen kann.

Üblicherweise sind am Endstück 1 noch Mittel vorhanden, über die der Betätigungshebel 4 bei Erreichen des in den Baugruppenträger vollständig eingeschobenen Zustands der Flachbaugruppe in der entsprechenden Position fixiert wird. Dieser eingeschobene Zustand ist in FIG 1 dargestellt. Vorteilhafterweise weist der Betätigungshebel 4 hierzu auf seiner Oberseite eine auf das Endstück 1 gerichtete, federnde und nach oben stehende Rastnase 24 auf, welche eine auf den Betätigungshebel 4 gerichtete und nach unten abgehende Rastkante 23 am Endstück 1 hintergreift.

In der gleichen weise ist auch an dem in FIG 2 dargestellten Eckbereich der Flachbaugruppe 2 eine entsprechende Anordnung aus einem oberen Endstück 3 mit einem daran drehbar gelagerten oberen Betätigungshebel 4 angebracht. Dieser greift dann zum Ein- und Aushebeln in eine entsprechende obere Querschiene eines Baugruppenträgers ein (nicht abgebildet).

Bei dem Betätigungselement nach dem Stand der Technik gemäß FIG 1 und FIG 2 ist im unteren oder oberen Endstück ein Schaltelement 25 integriert, wobei dieses durch den Betätigungshebel 4 bei Vorliegen von dessen fixierter Position (Schaltstellung A) betätigt wird. Es ist hiermit möglich, die am Betätigungshebel 4 angebrachte Flachbaugruppe 2 elektrisch freizuschalten, z.B. durch Aktivierung von deren Stromversorgung. Umgekehrt kann die Flachbaugruppe 2 auch elektrisch passiv geschaltet werden, indem im Moment einer Aushebelung der Flachbaugruppe 2 der Eingriff des Betätigungshebel 4 auf das in das Endstück 1 integrierte Schaltelement 25 endet und durch diese Freigabe des Schaltelements 25 die elektrische Stromversorgung der Flachbaugruppe 2 wieder passiviert wird.

Das Schaltelement 25 ist in einem bis in den Bereich der Rastkante 23 des Endstücks 1 reichenden Aufnahmeschlitz 28 gelagert. Ein Schaltteil des Schaltelements 25, z.B. ein Schalthebel 29, ragt somit in den Bereich unterhalb der nach unten abgehenden Rastkante 23 hinein und wird bei Erreichen des fixierten Zustands des Betätigungshebels 4 (Schaltstellung A) durch den Schaltschieber 26 des Verriegelungselements 6 des Betätigungshebels 4 betätigt, wenn sich der Betätigungshebel 4 in der Position A befindet. Das Verriegelungselement 6 ist über ein Verbindungsteil 30 mit dem Schaltschieber 26 verbunden.

Wenn der Betätigungshebel 4 in die Position B (vgl. FIG 2) verschoben wird, wird der Schalthebel 29 entlastet und das Schaltelement 25 in einen zweiten Schaltzustand umgeschaltet, wobei insbesondere eine Passivierung der Flachbaugruppe 2 erfolgt.

Daraufhin kann ein Aushebeln des Betätigungshebels 4 erfolgen, in dem dessen Griff teil 5 nach unten - in Richtung der Querschiene 10 - bewegt wird, wodurch sich die Rastnase 24 des Betätigungshebels 4 elastisch von der Rastkante 23 des Endstücks 1 löst. Durch die Verschiebung des Verriegelungselements 6 zwischen den Positionen A und B nach FIG 2 kann das Schaltelement 25 aktiviert und passiviert werden, und zwar unabhängig von einem vollständigen Lösen des Betätigungselements durch das geschilderte Aushebeln des Betätigungshebels 4 nach unten zum Herausnehmen der Flachbaugruppe 2 aus dem Baugruppenträger.

Weitere Einzelheiten zum Aufbau des Betätigungselements gemäß dem Stand der Technik nach den FIG 1 und 2 und insbesondere zur Funktion des Verriegelungselements 6 gehen aus der Gebrauchsmusteranmeldung 299 22 725.1 (Siemens) hervor, deren Offenbarungsgehalt ausdrücklich in diese Anmeldungsunterlagen aufgenommen wird.

Vorteilhafterweise ist das integrierte Schaltelement 25 über eine an dessen Anschlusskontakten 16 anbringbare Kabel- oder Kabelsteckverbindung mit der Flachbaugruppe 2 elektrisch verbindbar.
Es ist somit möglich, das Schaltelement 25 dauerhaft sicher und verschleißfrei über das Betätigungselement zu betätigen, wenn die Schaltmittel des Schaltelements 25 nur einen sehr geringen Schaltweg aufweisen.

Da die Aktiv-Passiv-Schaltfunktion vollständig in das Betätigungselement integriert ist, unterliegen Anwender des Frontsystems keiner Einschränkung bezüglich der Positionierung von Bauelementen auf einer mit einem derartigen Frontsystem ausgestatteten Flachbaugruppe. Insbesondere sind dort keine maßlich genauen Positionsfestlegungen bezüglich elektrischer Anschlüsse für das Schaltelement 25 erforderlich.

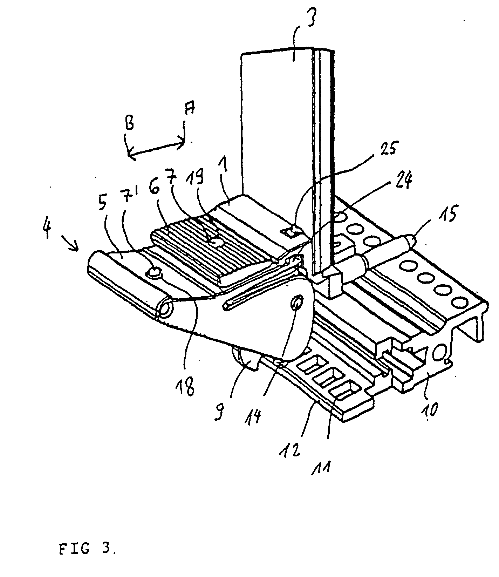

Soweit der Aufbau des erfindungsgemäßen Betätigungselements gemäß den FIG 3 bis 5 dem Aufbau des Betätigungselements nach dem Stand der Technik gemäß FIG 1 und FIG 2 entspricht, wurden identische Bezugszeichen verwendet, welche auch ohne ergänzende Erläuterung auch die bei der Figurenbeschreibung nach FIG 1 und FIG 2 dargestellten Funktionen besitzen.

FIG 3 zeigt ein elektrisches Anzeigeelement 7, welches in einer Ausnehmung 19 des Verriegelungselements 6 des Betätigungshebels 4 integriert ist. Hierdurch muss das Anzeigeelement nicht mehr in der Frontplatte 3 angebracht werden, sondern befindet sich platzsparend im Betätigungshebel 4 des Betätigungselements. Ferner ist ein elektrisches Anzeigeelement 7' abgebildet, welches in einer Ausnehmung 18 des Griffteils 5 des Betätigungshebels 4 integriert ist.

Das Anzeigeelement 7 dient insbesondere zur Anzeige von Schaltzuständen des Schaltelements 25, welches im Endstück 1 des Betätigungselements integriert ist.

Das Anzeigeelement 7 ist elektrisch mit dem Schaltelement 25 verbunden, einerseits zur Stromversorgung und andererseits zur Übermittlung von Informationen, z.B. hinsichtlich des Schaltzustandes des Schaltelements 25. Dabei erfolgt vorteilhafterweise eine Stromversorgung des Anzeigeelements 7 über die Anschlußkontakte 16 des Schaltelements 25.

Wenn das Verriegelungselement 6 sich nun in der Position B befindet und das Betätigungselement nach unten in Richtung der Querschiene 10 ausgehebelt werden kann, wird die Stromversorgung der elektrischen Anzeigeelemente 7, 7' unterbrochen. Hierfür besitzen die Anzeigeelemente 7, 7' an sich bekannte Anschlußkontakte, die wiederum über an sich bekannte Klemmkontakte mit Festkontakten am Endstück 1 zur Herstellung einer lösbaren elektrischen Verbindung verbindbar sind (nicht abgebildet).

Bei im Verriegelungselement 6 aufgenommenen elektrischen Anzeigeelement 7 ist letzteres mit dem Verriegelungselement 6 in die Schaltstellungen A und B verschiebbar. Hierfür müssen an sich bekannte elektrische Bewegungskontakte zur Stromversorgung der Anzeigeelemente 7, 7' vorgesehen sein (z.B. Kontaktschienen).

Bei einem im Griffteil 5 integriertem Anzeigeelement 7' kann eine derartige Stromversorgung des Anzeigelements 7' mit Bewegungskontakten entfallen. Es ist jedoch weiterhin erforderlich, eine unterbrechbare Stromversorgung mit der Flachbaugruppe 2 herzustellen, z.B. über die Anschlusskontakte des Schaltelements 25, um beim Aushebeln des Betätigungshebels 4 eine Unterbrechung der Stromversorgung des Anzeigeelements 7 zu ermöglichen.

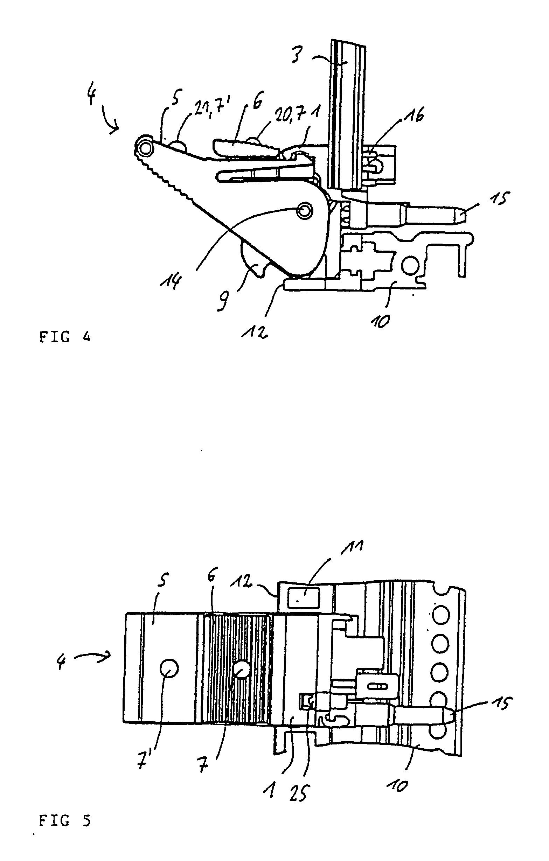

FIG 4 zeigt die in das Verriegelungselement 6 bzw. Griffteil 5 aufgenommenen Anzeigeelemente 7, 7', deren die Oberflächen 20, 21 jeweils das Verriegelungselement 6 und das Griffteil 5 überragen. Hierdurch können die elektrische Anzeigeelemente 7, 7' auch seitlich verbessert eingesehen werden und können vom Benutzer besser eingesehen werden.

Nach FIG 5 sind die Anzeigeelemente 7, 7' im wesentlichen mittig im Verriegelungselement 6 bzw. Griffteil 5 aufgenommen und können somit von beiden Seiten gleichermaßen vom Benutzer eingesehen werden.

Gemäß der Draufsicht auf das Betätigungselement nach FIG 5 sind die Anzeigeelemente 7, 7' im wesentlichen mittig im Verriegelungselement 6 und im Griffteil 5 des Betätigungshebels 4 angebracht, wodurch die Anzeigeelemente 7, 7' von sämtlichen Seiten des Betätigungselements gleichermaßen gut einsehbar sind.

## Patentansprüche

1. Betätigungselement zum Ein- und Aushebeln einer Flachbaugruppe (2) mit einem Endstück (1), das mit der Flachbaugruppe (2) verbindbar ist und einen an dem Endstück drehbar gelagerten Betätigungshebel (4) mit Griffteil (5) aufweist, wobei der Betätigungshebel (4) in dem mit der eingeschobenen Stellung der Flachbaugruppe (2) verbundenen Zustand mittels Verriegelungselement (6) fixierbar ist und wobei das Betätigungselement ein Schaltetement (25) aufweist, das im eingeschobenen Zustand bei fixiertem Betätigungshebel (4) von diesem betätigt wird und die Flachbaugruppe (2) elektrisch anschaltet,
**dadurch gekennzeichnet,**
**dass** der Betätigungshebel (4) oder das Verriegelungselement (6) mindestens ein elektrisches Anzeigeelement (7) aufweist, das in der verriegelten Einschubstellung des Betätigungshebels (4) über das betätigte Schaltelement (25) einschaltbar ist.

2. Betätigungselement nach Anspruch 1,
**dadurch gekennzeichnet,**
**dass** das Anzeigeelement (7) am Griffteil (5) des Betätigungshebels (4) angebracht ist.

3. Betätigungselement nach Anspruch 2,
**dadurch gekennzeichnet,**
**dass** das Anzeigeelement (7) teilweise in das Griffstück (5) integriert ist.

4. Betätigungselement nach Anspruch 2,
**dadurch gekennzeichnet,**
**dass** das Anzeigeelement (7) vollständig in das Griffteil (5) integriert ist.

5. Betätigungselement nach einem der Ansprüche 2 bis 4,
**dadurch gekennzeichnet,**
**dass** das Anzeigeelement (7) in einer Ausnehmung (18) des Griffteils (5) aufgenommen ist.

6. Betätigungselement nach Anspruch 1,
**dadurch gekennzeichnet,**
**dass** das Anzeigeelement (7) am Verriegelungselement (6) angebracht ist.

7. Betätigungselement nach Anspruch 6,
**dadurch gekennzeichnet,**
**dass** das Anzeigeelement (7) teilweise in das Verriegelungselement (6) integriert ist.

8. Betätigungselement nach Anspruch 6,
**dadurch gekennzeichnet,**
**dass** das Anzeigeelement (7) völlig in das Verriegelungselement (6) integriert ist.

9. Betätigungselement nach einem der Ansprüche 6 bis 8,
**dadurch gekennzeichnet,**
**dass** das Anzeigeelement (7) in einer Ausnehmung (19) des Verriegelungselementes (6) aufgenommen ist.

10. Betätigungselement nach Anspruch 1,
**dadurch gekennzeichnet,**
**dass** das Schaltelement (25) in das Endstück (1) integriert ist und das elektrische Anzeigeelement (7) elektrisch mit dem Schaltelement (25) verbunden ist.

11. Betätigungselement nach Anspruch 10,
**dadurch gekennzeichnet,**
**dass** die elektrische Verbindung zwischen Schaltelement (25) und Anzeigeelement (7) in Abhängigkeit von der Stellung des Betätigungshebels (4) herstellbar und unterbrechbar ist.

## Claims

1. Actuating element for levering a printed circuit board assembly (2) in and out, with an end piece (1), which can be connected to the printed circuit board assembly (2) and has an actuating lever (4) with a handle part (5), the said actuating lever being mounted on the end piece in rotatable fashion, it being possible for the actuating lever (4) to be fixed, by means of a locking element (6), in the state associated with the inserted position of the printed circuit board assembly (2) and the actuating element having a switching element (25) which, in the inserted state with the actuating lever (4) fixed, is actuated by the latter and electrically connects the printed circuit board assembly (2),
**characterized**
**in that** the actuating lever (4) or the locking element (6) has at least one electrical display element (7), which can be switched on by means of the actuated switching element (25) in the locked insertion position of the actuating lever (4).

2. Actuating element according to Claim 1,
**characterized**
**in that** the display element (7) is fitted to the handle part (5) of the actuating lever (4).

3. Actuating element according to Claim 2,
**characterized**
**in that** the display element (7) is partially integrated into the handle piece (5).

4. Actuating element according to Claim 2,
**characterized**
**in that** the display element (7) is completely integrated into the handle part (5).

5. Actuating element according to one of Claims 2 to 4,
**characterized**
**in that** the display element (7) is accommodated in a recess (18) of the handle part (5).

6. Actuating element according to Claim 1,
**characterized**
**in that** the display element (7) is fitted to the locking element (6).

7. Actuating element according to Claim 6,
**characterized**
**in that** the display element (7) is partially integrated into the locking element (6).

8. Actuating element according to Claim 6,
**characterized**
**in that** the display element (7) is completely integrated into the locking element (6).

9. Actuating element according to one of Claims 6 to 8,
**characterized**
**in that** the display element (7) is accommodated in a recess (19) of the locking element (6).

10. Actuating element according to Claim 1,
**characterized**
**in that** the switching element (25) is integrated into the end piece (1) and the electrical display element (7) is electrically connected to the switching element (25).

11. Actuating element according to Claim 10,
**characterized**
**in that** the electrical connection between switching element (25) and display element (7) can be produced and interrupted in a manner dependent on the position of the actuating lever (4).

## Revendications

1. Elément d'actionnement servant à activer et désactiver par levier un agrégat plat (2), comportant un embout (1) qui peut être relié à l'agrégat plat (2) et présente un levier d'actionnement (4) installé de manière pivotable sur l'embout avec une pièce de saisie (5), le levier d'actionnement (4) pouvant être fixé, dans l'état lié à la position enfoncée de l'agrégat plat (2), au moyen de l'élément de verrouillage (6), et l'élément d'actionnement présentant un élément de commutation (25) qui, dans l'état enfoncé, lorsque le levier d'actionnement est fixé, est actionné par celui-ci et active électriquement l'agrégat plat (2), **caractérisé en ce que** le levier d'actionnement (4) ou l'élément de verrouillage (6) présente au moins un élément d'affichage électrique (7) qui peut être activé, en position d'enfoncement verrouillée du levier d'actionnement (4), par l'élément de commutation actionné (25).

2. Elément d'actionnement selon la revendication 1, **caractérisé en ce que** l'élément d'affichage (7) est installé sur la pièce de saisie (5) du levier d'actionnement (4).

3. Elément d'actionnement selon la revendication 2, **caractérisé en ce que** l'élément d'affichage (7) est intégré partiellement dans la pièce de saisie (5).

4. Elément d'actionnement selon la revendication 2, **caractérisé en ce que** l'élément d'affichage (7) est intégré totalement dans la pièce de saisie (5).

5. Elément d'actionnement selon l'une quelconque des revendications 2 à 4, **caractérisé en ce que** l'élément d'affichage (7) est reçu dans un évidement (18) de la pièce de saisie (5).

6. Elément d'actionnement selon la revendication 1, **caractérisé en ce que** l'élément d'affichage (7) est installé sur l'élément de verrouillage (6).

7. Elément d'actionnement selon la revendication 6, **caractérisé en ce que** l'élément d'affichage (7) est intégré partiellement dans l'élément de verrouillage (6).

8. Elément d'actionnement selon la revendication 6, **caractérisé en ce que** l'élément d'affichage (7) est intégré totalement dans l'élément de verrouillage (6).

9. Elément d'actionnement selon l'une quelconque des revendications 6 à 8, **caractérisé en ce que** l'élément d'affichage (7) est reçu dans un évidement (19) de l'élément de verrouillage (6).

10. Elément d'actionnement selon la revendication 1, **caractérisé en ce que** l'élément de commutation (25) est intégré dans l'embout (1) et que l'élément d'affichage électrique (7) est relié électriquement à l'élément de commutation (25).

11. Elément d'actionnement selon la revendication 10, **caractérisé en ce que** la liaison électrique entre l'élément de commutation (25) et l'élément d'affichage (7) peut être établie et interrompue en fonction de la position du levier d'actionnement (4).
